# NEW EUROPEAN PATENT SPECIFICATION

(11) **EP 2 208 237 B2**
(45) Date of publication and mention of the opposition decision: **16.04.2014**
(45) Mention of the grant of the patent: 22.06.2011
(21) Application number: 07847831.0
(22) Date of filing: 05.12.2007
(51) Int. Cl.: H01L 31/18, H01L 21/677, H05K 3/12, B41F 15/26, H01L 21/687, B41F 15/08, B41F 15/16, H01L 31/0224

(54) **POSITIONING DEVICE TO POSITION ONE OR MORE ELECTRONIC CIRCUIT BOARDS, IN PARTICULAR FOR PHOTOVOLTAIC CELLS, IN A METAL-DEPOSITION UNIT**
POSITIONIERUNGSVORRICHTUNG ZUR POSITIONIERUNG VON EINER ODER MEHREREN ELEKTRONISCHEN SCHALTPLATTEN, INSBESONDERS VON PHOTOVOLTAISCHEN ZELLEN, IN EINER METALLABSCHEIDEEINHEIT
DISPOSITIF DE POSITIONNEMENT POUR POSITIONNER UNE OU PLUSIEURS CARTES DE CIRCUIT ÉLECTRONIQUE, EN PARTICULIER POUR DES PILES PHOTOVOLTAÏQUES, DANS UNE UNITÉ DE DÉPÔT DE MÉTAL

(30) Priority: 04.09.2007 IT UD20070156
(43) Date of publication of application: 21.07.2010
(73) Proprietor: APPLIED MATERIALS ITALIA S.R.L., 31048 San Biagio di Callalta (TV) (IT)
(72) Inventor: BACCINI, Andrea, I-31048 San Biagio Di Callalta (IT)
(74) Representative: Zimmermann & Partner
(86) International application number: PCT/EP2007/063336
(87) International publication number: WO 2009/030284

(56) References cited:
- EP-B1- 0 535 338
- DE-B3-102006 015 686
- DE-B3-102006 015 686

## Description

### FIELD OF THE INVENTION

The present invention concerns a positioning device for electronic circuit boards, in particular but not only green-tape or wafers for photovoltaic cells, in a metal-deposition unit, for example by means of serigraphy. In particular, the positioning device according to the present invention is applied to a transport member, for example with a rotary turret or a turntable, which transports the electronic circuit boards from a loading station to a discharge station, passing through at least a metal-deposition station.

### BACKGROUND OF THE INVENTION

Plants for working electronic circuit boards, for example those called wafers, are known, for example for the production of photovoltaic cells, which comprise at least a unit to deposit metal tracks on the wafers and a positioning device that positions and transports the wafers with respect to the deposition unit, and possible other working stations.

A positioning device is known which comprises at least a belt to feed metal wafers and a rotary turret or turntable, on which the wafers fed by the feed belt are positioned. The turret can be rotated by determinate angles in order to transport and position each wafer in defined operating positions of the deposition unit, so as to achieve the photovoltaic cells.

This type of transport member needs specific members to position the wafers, which comprise at least a supporting plate mounted on the turret and on which the wafer is initially deposited as it exits from the conveyor belt.

To guarantee precision in depositing each metal track on the wafers, it is necessary to associate with the positioning device a complex calibration and alignment station, in order to correct the position of the wafer on the plate, and also a specific pick-up and discharge member, which moves the finished wafers individually towards a discharge belt.

This entails a consequent increase in the production costs and the operating times of the plant, with an inevitable reduction in productivity.

A positioning device is also known in which, instead of the supporting plate, there is a sliding strip on the turret, made of transpirable material, for example paper, wound between two winding/unwinding rollers. Reference is also made to prior art document DE 10 2006015686 B3.

This solution, although it allows to guide the deposition of the wafers on the turret, entails long maintenance steps and hence inactivity of the plant, due to the periodic need to replace the paper strip once the latter is completely wound onto one of the rollers.

Furthermore, the maintenance steps are rather complex and entail the intervention of particularly specialized personnel.

One purpose of the present invention is to achieve a positioning device for electronic circuit boards, which is easy and economical to make and which allows to position the boards precisely on the transport member, without long and costly steps being necessary to correct the position of the boards.

Another purpose of the present invention is to achieve a positioning device for electronic circuit boards which does not need long, complex and costly maintenance steps in order to be replaced.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

A positioning device according to the present invention is applied to position electronic circuit boards, for example, but not only, silicon-based wafers, with respect to an operating unit.

The positioning device according to the present invention comprises a rotary member able to rotate selectively at least between a first operating position and a second operating position, and a positioning member able to be mounted on the rotary member.

According to a characteristic feature of the present invention, the positioning member comprises at least a frame, which is mounted removably on the rotary member, and a strip made of transpirable material on which each electronic circuit board is rested.

Moreover, the strip is wound between a pair of winding/unwinding rollers, pivoted on the frame.

With the present invention we therefore have that the positioning device is selectively removable from the rotary element, so that it can be replaced by another, for example of different size and/or function, or simply when the transpirable strip is finished.

The selective removability of the device thus allows to speed up and simplify the operations to replace the strip, limiting any possible interruptions in production to a minimum, increasing productivity and reducing the overall costs of management of the transport member.

According to a variant, the removable frame comprises rapid attachment means conformed so as to allow at least the reciprocal mechanical, electric and possibly pneumatic connections of the device to the rotary element, with a limited number of operations, advantageously only the sliding insertion of the frame into a coordinated seating made on the rotary element.

According to another variant, the device according to the invention comprises at least a driven roller able to be selectively brought into cooperation with one of the two winding/unwinding rollers, so as to determine the movement of the transpirable strip, and hence of the electronic circuit board towards or from the rotary element. Advantageously, the driven roller is mounted on the rotary element in correspondence with a loading and/or unloading station for the electronic circuit boards.

According to another variant, the removable frame also comprises lighting means disposed under the transpirable strip in order to determine a rear-illumination effect, and facilitate operations to control and correct the position of the electronic circuit board on the transpirable strip.

According to another variant, the removable frame comprises suction means disposed in cooperation with the transpirable strip and able to hold the electronic circuit board, through pneumatic depression, in a determinate operating position above the transpirable strip.

### BRIEF DESCRIPTION OF THE DRAWINGS

These and other characteristics of the present invention will become apparent from the following description of a preferential form of embodiment, given as a non-restrictive example with reference to the attached drawings wherein:

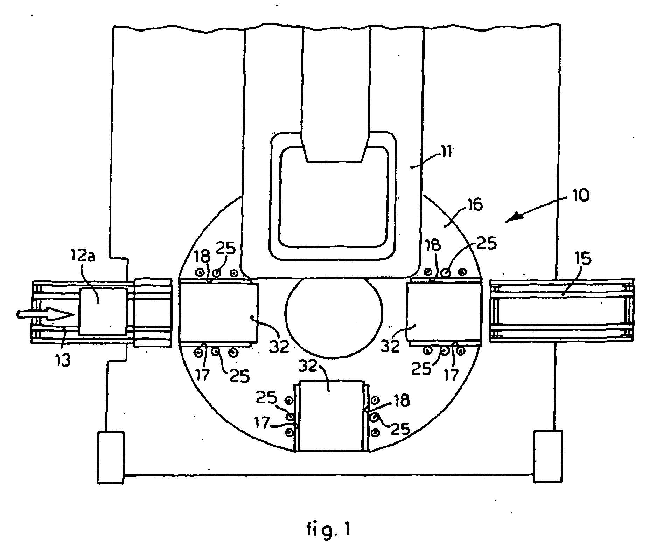

- fig. 1 is a schematic view from above of a unit to deposit metal on silicon wafers provided with a positioning device according to the present invention;
- fig. 2 is a lateral schematic view, partly in section, of the deposition unit in fig. 1;
- fig. 3 shows an enlarged detail, partly in section, of the positioning device in fig. 1;
- figs. 4a-4e show in sequence some operating steps of the deposition unit in fig. 1.

### DETAILED DESCRIPTION OF A PREFERENTIAL FORM OF EMBODIMENT

With reference to the attached drawings, a positioning device 10 according to the present invention is mounted on a metal-deposition unit 11 of a plant for making photovoltaic cells 12b starting from electronic circuit boards, for example wafers 12a.

The wafers 12a and the photovoltaic cells 12b are moved and positioned with respect to the metal-deposition unit 11 by means of: a first conveyor belt 13 to feed the wafers 12a; a second conveyor belt 15 to discharge the photovoltaic cells 12b; and a rotary turret 16 interposed between the two belts 13 and 15 which, as will be explained hereafter, transports the wafers 12a and the photovoltaic cells 12b in turntable fashion, between the various operating positions.

The positioning device 10 comprises one or more positioning members 17, in this case four, offset angularly with respect to each other by 90°, and mounted on the rotary turret 16, inside coordinated assembly seatings 18 made peripherally on the rotary turret 16.

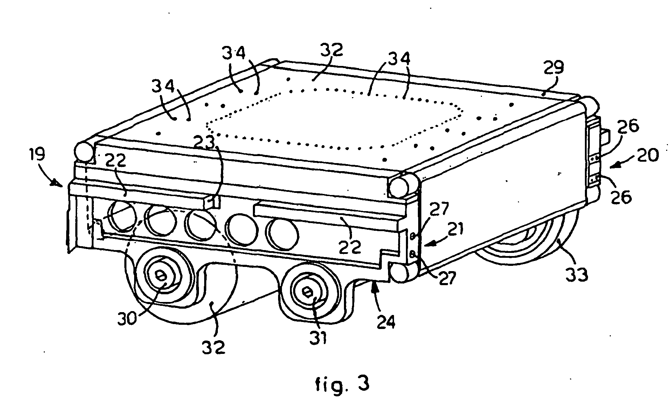

Each positioning member 17 comprises a removable frame 24 (fig. 3) that comprises rapid attachment members, respectively mechanical 19, electric, 20 and pneumatic 21.

In particular, the mechanical attachment members 19 comprise two linear ribs 22 made along the sides of the frame 24 and able to slide in mating attachment grooves, not shown, made inside each assembly seating 18.

The linear ribs 22 have an interruption 23 that defines the positioning seating of relative attachment pins 25, in order to temporarily clamp the frame 24 in the relative assembly seating 18.

The electric attachment members 20 comprise two or more metal platelets 26 mounted on the front wall of the frame 24, and able to be contacted by corresponding conductors, not shown, provided inside the assembly seating 18.

The pneumatic attachment members 21 comprise two or more pipes 27 also made on the front wall of the frame 24, and able to be connected with corresponding pneumatic connections, not shown, provided inside the assembly seating 18.

The frame 24 also comprises an upper surface 29 to support the wafer 12a or the photovoltaic cell 12b, and two supporting rollers 30 and 31 around which a paper strip 32 is wound.

The wafer 12a arriving from the first conveyor belt 13, or the photovoltaic cell 12b to be taken towards the second conveyor belt 15, are positioned on the paper strip 32.

In particular, the upper surface 29 comprises a plurality of suction holes 34, able to define a pneumatic depression which allows the wafer 12a or the photovoltaic cell 12b to be partly held on the frame 24.

Advantageously, the upper surface 29 is also rear-illuminated so as to promote the possible operations to sight and correct the position of the photovoltaic cell 12b on the paper strip 32.

The paper strip 32 is disposed initially in a coil on a first of the two supporting rollers 30, it is disposed above the upper surface 29 and is wound onto a second of the two supporting rollers 31. On the frame there is also a movement roller 33, keyed to the second supporting roller 31.

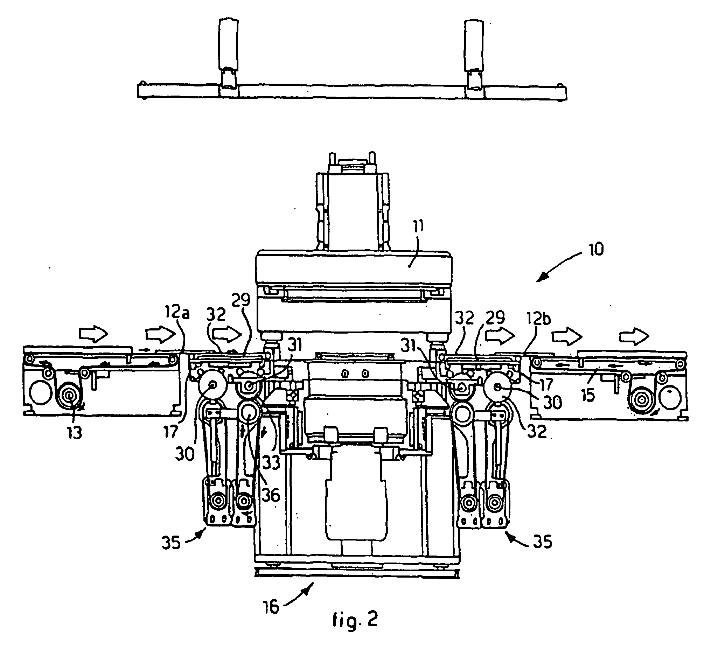

The positioning device 10 also comprises (fig. 2) at least a movement mechanism 35, in this case two, mounted on a fixed part of the rotary turret 16, in correspondence with the first conveyor belt 13 and the second conveyor belt 15.

Each movement mechanism 35 is provided with at least a driven wheel 36 disposed in such a manner as to contact the movement roller 33 and actuate the rotation thereof, to wind the paper strip 32. This type of motion transmission is known as a "pinch roller".

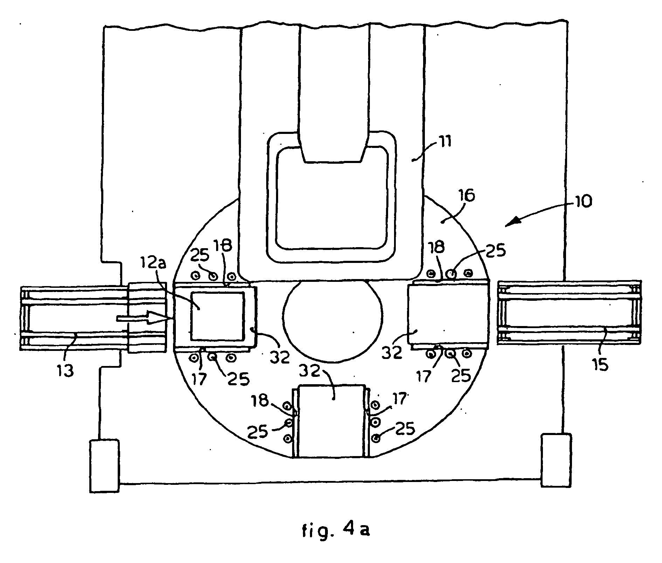

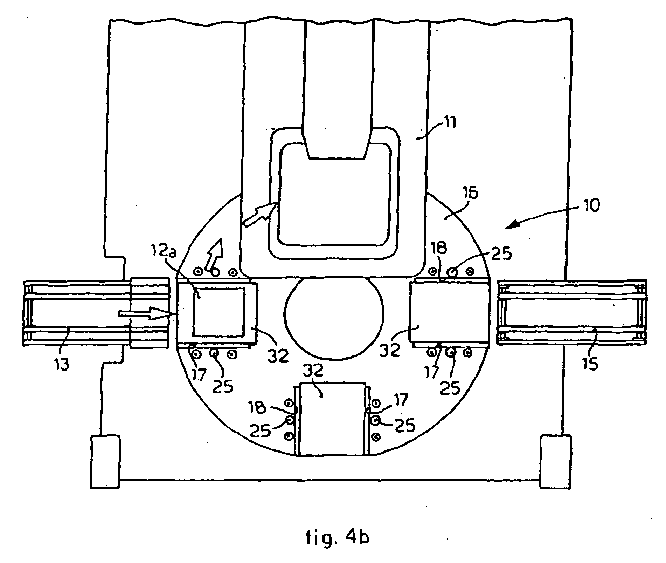

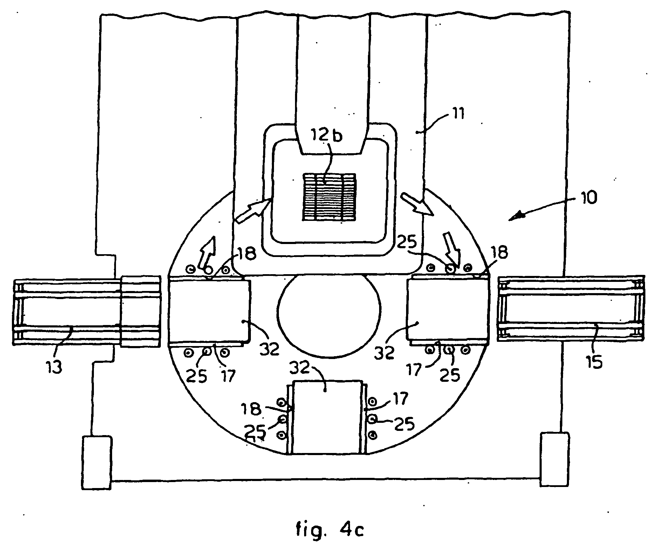

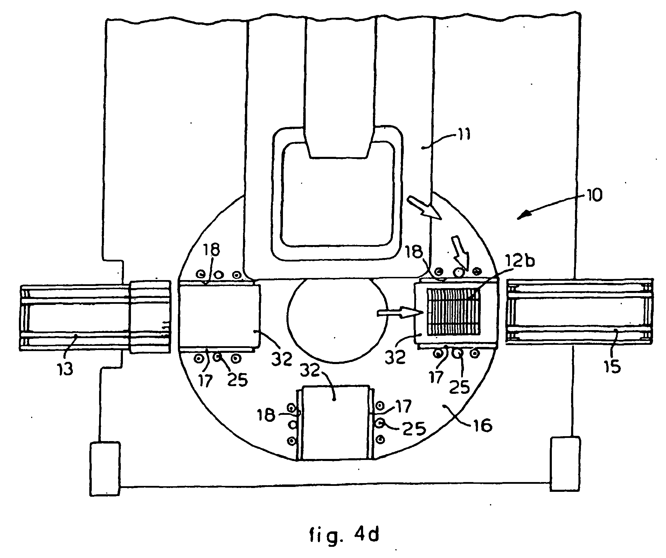

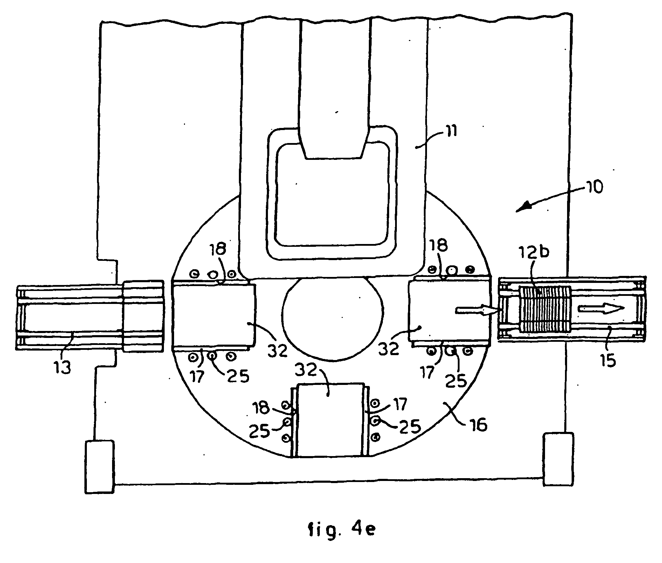

With reference to figs. 4a to 4e, the device 10 according to the present invention functions as follows.

To give a non-restrictive example, figs. 4a to 4e show schematically the movement cycle of a single silicon wafer 12a from which the photovoltaic cell 12b is made. It is clear that in real operating conditions the wafers 12a may be loaded substantially in a continuous cycle, in order to optimize the productivity of the photovoltaic cells 12b.

The silicon wafers 12a are transported by the first conveyor belt 13 towards the rotary turret 16, which is positioned angularly so as to have a first frame 24 of the positioning device 10 facing towards the first conveyor belt 13, with the paper strip 32 in a winding movement around the second supporting roller 31.

The silicon wafer 12a is then positioned on the paper strip 32, and is moved by the latter until it reaches a substantially central position with respect to the upper surface 29. Simultaneously with the movement of the silicon wafer 12a, a pneumatic depression is created through the suction holes 34, in order to hold the wafer 12a in close proximity to the paper strip 32, preventing as much as possible any lateral movements thereof.

Keeping the pneumatic depression active, the rotary turret 16 is made to rotate by about 90°, to take the silicon wafer 12a into cooperation with the metal-deposition unit 11.

During this step, a new silicon wafer 12a can be loaded, on a paper strip 32 of a following frame 24.

Once the metal has been deposited, and therefore the photovoltaic cell 12b has been formed, the rotary turret 16 is rotated by another 90°, so as to take the frame 24 in correspondence with the second conveyor belt 15.

In this position, the paper strip 32 is moved to transport the photovoltaic cell 12b onto the second conveyor belt 15, and thus to discharge it towards other operating stations of the plant.

When the paper strip 32 is finished, the attachment pins 25 are removed, and the corresponding frame 24 is removed from its assembly seating 18 by sliding the mechanical attachment members 19. The electric attachment members 20 and the pneumatic attachment members 21 are conformed so as to be automatically disconnected as soon as the frame 24 begins to be removed.

A new frame 24 is then prepared, or the same frame 24 with a new paper strip 32, and is re-inserted into the assembly seating 18. This is done by sliding the mechanical attachment members 19. The electric attachment members 20 and the pneumatic attachment members 21 are conformed so as to be automatically connected as soon as the insertion of the frame 24 into the assembly seating 18 has been completed.

It comes within the field of the present invention, for example, to provide that instead of the attachment pins 25 and the relative interruptions 23, the mechanical clamping of the frame 24 in the relative assembly seating 18 can be achieved by means of snap-in mechanisms, servo commanded electronically or pneumatically, by same-shape coupling or in other ways, able to guarantee that the frame is clamped in an easily removable manner.

It also comes within the field of the present invention to provide that instead of the paper strip 32 a strip of any other transpirable material can be used.

It is also clear that, although the present invention has been described with reference to specific examples, a person of skill in the art shall certainly be able to achieve many other equivalent forms of positioning device for silicon-based wafers, in particular for photovoltaic cells, in a metal-deposition unit, having the characteristics as set forth in the claims and hence all coming within the field of protection defined thereby.

## Claims

1. Positioning device to position electronic circuit boards (12a) with respect to an operating unit (11) comprising a rotary member (16) configured to rotate selectively at least between a first operating position and a second operating position, and a positioning member (17) configured to be mounted on said rotary member (16), **characterized in that** said positioning member (17) comprises at least a frame (24) which is shaped to be mounted removably on said rotary member (16) and having rapid attachment means (19, 20, 21) being configured to allow at least the reciprocal mechanical and electric connections of the removable frame (24) to said rotary member (16), and a strip (32) made of transpirable material on which each of said electronic circuit boards (12a) is configured to be rested, where in strip belt (32) is wound between a pair of winding/unwinding rollers (30, 31) pivoted on said frame (24).

2. Positioning device as in claim 1, **characterized in that** said rapid attachment means comprises a mechanical attachment (19) comprising linear ribs (22) made along the sides of said removable frame (24) and configured to cooperate with mating attachment grooves made inside each assembly seating (18).

3. Positioning device as in claim 2, **characterized in that** said linear ribs (22) have at least an interruption (23) configured to define the positioning seating of relative attachment pins (25), for the temporary clamping of the removable frame (24) in said assembly seating (18).

4. Positioning device as in any claim from 1 to 3, **characterized in that** the rapid attachment means comprises an electric attachment (20) comprising one or more metal plates (26) mounted on a front wall of said removable frame (24) and configured to be contacted by corresponding electric conductors provided inside said assembly seating (18).

5. Positioning device as in any claim from 1 to 4, **characterized in that** the rapid attachment means comprises a pneumatic attachment (21) comprising one or more pipes (27) made on a front wall of said removable frame (24), and configured to connect with corresponding pneumatic connections provided inside said assembly seating (18).

6. Positioning device as in any claim from 1 to 5, **characterized in that** it comprises movement means (35) mounted in determinate fixed positions on said rotary member (16), in order to actuate the selective movement of said transpirable strip (32) around said pair of winding/unwinding rollers (30, 31).

7. Positioning device as in claim 6, **characterized in that** said movement means (35) comprises at least a driven roller (36) configured to be selectively taken into cooperation with one said two winding/unwinding rollers (30, 31), in order to determine the movement of said transpirable strip (32).

8. Positioning device as in any claim hereinbefore, **characterized in that** the removable frame (24) comprises lighting means disposed under the transpirable strip (32), in order to determine a rear lighting effect.

9. Positioning device as in any claim hereinbefore, **characterized in that** the removable frame (24) comprises suction means (34) disposed in cooperation with said transpirable strip (32) and configured to hold said electronic circuit boards (12a) in a determinate operating position.

10. Positioning device as in claim 1, wherein said electronic circuit boards are silicon-based wafers.

## Patentansprüche

1. Positionierungsgerät zum Positionieren elektronischer Platinen (12a) bezüglich einer Betriebseinheit (11), umfassend ein Drehelement (16), das eingerichtet ist, mindestens zwischen einer ersten Betriebsposition und einer zweiten Betriebsposition selektiv zu rotieren, und ein Positionierelement (17), das eingerichtet ist, auf dem Drehelement (16) befestigt zu werden, **dadurch gekennzeichnet, dass** das Positionierelement (17) mindestens einen Rahmen (24) umfasst, der geformt ist, um entfernbar auf dem Drehelement (16) befestigt zu werden und der ein Schnellanbringungsmittel (19, 20, 21) aufweist, das eingerichtet ist, mindestens die wechselseitigen mechanischen und elektrischen Verbindungen des entfernbaren Rahmens (24) zu dem Drehelement (16) zu erlauben, und einen Streifen (32), der aus transpirierbarem Material gefertigt ist und auf welchem jede der elektronischen Platinen (12a) aufgelegt zu werden eingerichtet ist, wobei der Streifen (32) zwischen einem Paar von Aufwicklungs/Abwicklungsrollen (30, 31) gewunden ist, die auf dem Rahmen (24) drehbar gelagert sind.

2. Positionierungsgerät nach Anspruch 1, **dadurch gekennzeichnet, dass** das Schellanbringungsmittel eine mechanische Anbringung (19) umfasst, welche entlang den Seiten des entfernbaren Rahmens (24) gefertigte, lineare Rippen (22) umfasst und eingerichet ist, mit passenden Anbringungsrillen zusammenzuwirken, die in jeder Anordnungsaufnahme (18) gefertigt sind.

3. Positionierungsgerät nach Anspruch 2, **dadurch gekennzeichnet, dass** die linearen Rippen (22) mindestens eine Unterbrechung (23) aufweisen, die eingerichtet ist, den Positionierungssitz von relativen Anbringungsstiften (25) für die temporäre Anklammerung des entfernbaren Rahmens (24) in der Anordnungsaufnahme (18) zu definieren.

4. Positionierungsgerät nach einem der Ansprüche 1 bis 3, **dadurch gekennzeichnet, dass** das Schnellanbringungsmittel eine elektrische Anbringung (20) umfasst, die eine oder mehrere Metallplatten (26) umfasst, die auf der Vorderwand des entfernbaren Rahmens (24) angebracht sind und die eingerichtet sind, durch entsprechende elektrische Leiter kontaktiert zu werden, die innerhalb der Anordnungsaufnahme (18) bereitgestellt sind.

5. Positionierungsgerät nach einem der Ansprüche 1 bis 4, **dadurch gekennzeichnet, dass** das Schnellanbringungsmittel eine pneumatische Anbringung (21) umfasst, die eine oder mehrere Röhren (27) umfasst, die auf der Vorderwand des entfernbaren Rahmens (24) gefertigt sind und eingerichtet sind, sich mit entsprechenden pneumatischen Verbindungen zu verbinden, die innerhalb der Anordnungsaufnahme (18) bereitgestellt sind.

6. Positionierungsgerät nach einem der Ansprüche 1 bis 5, **dadurch gekennzeichnet, dass** es ein Bewegungsmittel (35) umfasst, das in bestimmten fixen Positionen auf dem Drehelement (16) angebracht ist, um die selektive Bewegung des transpirierbaren Streifens (32) um das Paar von Aufwicklungs/Abwicklungsrollen (30,31) auszulösen.

7. Positionierungsgerät nach Anspruch 6, **dadurch gekennzeichnet, dass** das Bewegungsmittel (35) mindestens eine angetriebene Rolle (36) umfasst, die eingerichtet ist, selektiv in Zusammenwirkung mit einer der zwei Aufwicklungs/Abwicklungsrollen (30, 31) gebracht zu werden, um die Bewegung des transpirierbaren Streifens (32) zu bestimmen.

8. Positionierungsgerät nach einem der vorhergehenden Ansprüche, **dadurch gekennzeichnet, dass** der entfernbare Rahmen (24) ein Beleuchtungsmittel umfasst, das unter dem transpirierbaren Streifen (32) angeordnet ist, um einen Rückseitenbeleuchtungseffekt zu bestimmen.

9. Positionierungsgerät nach einem der vorhergehenden Ansprüche, **dadurch gekennzeichnet, dass** der entfernbare Streifen (24) ein Saugmittel (34) umfasst, das in Zusammenwirkung mit dem transpirierbaren Streifen (32) angeordnet ist und eingerichtet ist, die elektronischen Platinen (12a) in einer bestimmten Betriebsposition zu halten.

10. Positionierungsgerät nach Anspruch 1, wobei die elektronischen Platinen siliziumbasierte Wafer sind.

## Revendications

1. Dispositif de positionnement pour positionner des cartes de circuit électronique (12a) par rapport à une unité fonctionnelle (11) comprenant un élément rotatif (16) configuré pour tourner sélectivement au moins entre une première position fonctionnelle et une deuxième position fonctionnelle, et un élément de positionnement (17) configuré pour être monté sur ledit élément rotatif (16), **caractérisé en ce que** ledit élément de positionnement (17) comprend au moins un bâti (24) profilé pour être monté de manière amovible sur ledit élément rotatif (16) et ayant des moyens de fixation rapide (19, 20, 21) qui sont configurés pour permettre au moins les connexions mécaniques et électriques mutuelles du bâti amovible (24) avec ledit élément rotatif (16), et une bande (32) constituée de matériau transpirant, sur laquelle chacune desdites cartes de circuit électronique (12a) est configurée pour être posée, dans lequel la bande (32) est enroulée entre une paire de rouleaux d'enroulement/déroulement (30, 31) commandés en rotation sur ledit bâti (24).

2. Dispositif de positionnement selon la revendication 1, **caractérisé en ce que** lesdits moyens de fixation rapide comprennent une fixation mécanique (19) comprenant des nervures linéaires (22) réalisées le long des côtés dudit bâti amovible (24) et configurées pour coopérer avec des rainures de fixation conjuguées réalisées à l'intérieur de chaque siège d'assemblage (18).

3. Dispositif de positionnement selon la revendication 2, **caractérisé en ce que** lesdites nervures linéaires (22) ont au moins une interruption (23) configurée pour définir le siège de positionnement de goupilles de fixation correspondantes (25), pour le blocage provisoire du bâti amovible (24) dans ledit siège d'assemblage (18).

4. Dispositif de positionnement selon l'une quelconque des revendications 1 à 3, **caractérisé en ce que** les moyens de fixation rapide comprennent une fixation électrique (20) comprenant une ou plusieurs plaques métalliques (26) montées sur une paroi avant dudit bâti amovible (24) et configurées pour venir en contact par des conducteurs électriques correspondants disposés à l'intérieur dudit siège d'assemblage (18).

5. Dispositif de positionnement selon l'une quelconque des revendications 1 à 4, **caractérisé en ce que** les moyens de fixation rapide comprennent une fixation pneumatique (21) comprenant un ou plusieurs tubes (27) réalisés sur une paroi avant dudit bâti amovible (24) et configurés pour se connecter avec des connexions pneumatiques correspondantes disposées à l'intérieur dudit siège d'assemblage (18).

6. Dispositif de positionnement selon l'une quelconque des revendications 1 à 5, **caractérisé en ce qu'**il comprend des moyens de mouvement (35) montés dans des positions fixes déterminées sur ledit élément rotatif (16), de manière à activer le mouvement sélectif de ladite bande transpirante (32) autour de ladite paire de rouleaux d'enroulement/déroulement (30, 31).

7. Dispositif de positionnement selon la revendication 6, **caractérisé en ce que** lesdits moyens de mouvement (35) comprennent au moins un rouleau commandé (36) configuré pour être amené sélectivement en coopération avec un desdits deux rouleaux d'enroulement/déroulement (30, 31), de manière à déterminer le mouvement de ladite bande transpirante (32).

8. Dispositif de positionnement selon l'une quelconque des revendications précédentes, **caractérisé en ce que** le bâti amovible (24) comprend des moyens d'éclairage disposés sous la bande transpirante (32), de manière à déterminer un effet de rétro-éclairage.

9. Dispositif de positionnement selon l'une quelconque des revendications précédentes, **caractérisé en ce que** le bâti amovible (24) comprend des moyens d'aspiration (34) disposés en coopération avec ladite bande transpirante (32) et configurés pour maintenir lesdites cartes de circuit électronique (12a) dans une position fonctionnelle déterminée.

10. Dispositif de positionnement selon la revendication 1, dans lequel lesdites cartes de circuit électronique sont des plaquettes à base de silicium.
